# EUROPÄISCHE PATENTSCHRIFT

(11) **EP 2 011 169 B1**
(45) Veröffentlichungstag und Bekanntmachung des Hinweises auf die Patenterteilung: **14.03.2012**
(21) Anmeldenummer: 07728184.8
(22) Anmeldetag: 17.04.2007
(51) Int. Cl.: H01L 41/047

(54) **PIEZOAKTOR MIT AUSSEN KONTAKTIERTEN INNENELEKTRODEN EINES PIEZOELEMENTS**
PIEZO ACTUATOR COMPRISING EXTERNALLY CONTACTED INNER ELECTRODES OF A PIEZO ELEMENT
PIÉZOACTIONNEUR DOTÉ D'ÉLECTRODES INTERNES, À CONTACT EXTERNE, D'UN ÉLÉMENT PIÉZOÉLECTRIQUE

(30) Priorität: 19.04.2006 DE 102006018056
(43) Veröffentlichungstag der Anmeldung: 07.01.2009
(73) Patentinhaber: Robert Bosch GmbH, 70442 Stuttgart (DE)
(72) Erfinder: HOHMANN, Eugen, 96191 Viereth-Trunstadt (DE); FERGEN, Immanuel, 76646 Bruchsal (DE)
(86) Internationale Anmeldenummer: PCT/EP2007/053719
(87) Internationale Veröffentlichungsnummer: WO 2007/118879

(56) Entgegenhaltungen:
- EP-A1- 0 844 678
- WO-A-03/105246
- DE-A1- 10 208 417
- DE-A1- 10 236 986

## Beschreibung

Die Erfindung betrifft einen Piezoaktor, beispielsweise zur Betätigung eines mechanischen Bauteils wie ein Ventil oder dergleichen, mit außen kontaktierten Innenelektroden eines Piezoelements nach den gattungsgemäßen Merkmalen des Anspruchs 1.

### Stand der Technik

Es ist an sich bekannt, dass zum Aufbau des zuvor erwähnten Piezoaktors ein Piezoelement so eingesetzt werden kann, dass unter Ausnutzung des sogenannten Piezoeffekts eine Steuerung des Nadelhubes eines Ventils oder dergleichen vorgenommen werden kann. Das Piezoelement ist aus einem Material mit einer geeigneten Kristallstruktur so aufgebaut, dass bei Anlage einer äußeren elektrischen Spannung eine mechanische Reaktion des Piezoelements erfolgt, die in Abhängigkeit von der Kristallstruktur und der Anlagebereiche der elektrischen Spannung einen Druck oder Zug in eine vorgebbare Richtung darstellt. Derartige Piezoaktoren eignen sich beispielsweise für Anwendungen, bei denen Hubbewegungen unter hohen Betätigungskräften und hohen Taktfrequenzen ablaufen.

Beispielsweise ist ein solcher Piezoaktor als Bestandteil eines Piezoinjektors aus der DE 10026005 A1 bekannt, der zur Ansteuerung der Düsennadel bei Injektoren zur Einspritzung von Kraftstoff in den Brennraum eines Verbrennungsmotors verwendet werden kann. Bei diesem Piezoaktor ist ein Piezoelement als Stapel mehrerer elektrisch miteinander gekoppelter piezokeramischer Schichten aufgebaut, der unter Vorspannung zwischen zwei Anschlägen gehalten ist. Jede piezokeramische Schicht ist als Piezolage zwischen zwei Innenelektroden eingefasst, über die von außen eine elektrische Spannung angelegt werden kann. Aufgrund dieser elektrischen Spannung führen die piezokeramischen Schichten dann jeweils kleine Hubbewegungen in Richtung des Potenzialgefälles aus, die sich zum Gesamthub des Piezoaktors addieren. Dieser Gesamthub ist über die Höhe der angelegten Spannung veränderbar und kann auf ein mechanisches Stellglied übertragen werden.

Bei dem zuvor erwähnten Piezoaktor wird zur Heranführung der unterschiedlichen Potenziale eine wechselseitige seitliche Kontaktierung der Innenelektroden über äußere Elektroden vorgenommen, bei der leitende Flächen auf jeweils einer Seitenfläche des Piezoelements angebracht sind, die mit den jeweiligen Innenelektroden kontaktiert sind.

Bei einer Betätigung des Piezoaktors treten unterschiedliche mechanische Kräfte im Bereich der Innenelektroden sowie im Bereich der Kontaktierungen an den Außenelektroden auf, die zu mechanischen Spannungen und dadurch zu Rissen in den Außenelektroden führen können. Die Außenelektroden müssen dann wiederum mit Anschlusselektroden versehen werden, die weiter nach außen geführt werden und in der Regel auch mechanischen Spannungen standhalten müssen.

In der DE 19928190 A1 ist ein Piezoaktor beschrieben, bei dem zur Erreichung einer gewissen Flexibilität mindestens eine Schicht der jeweilige Außenelektrode netz-, sieb- oder gewebeartig auf jeweils einer Seitenfläche verteilt aufgebaut und zumindest punktweise mit den jeweiligen Innenelektroden kontaktiert ist. Darüber hinaus ist auch aus der DE 19928178 A1 bekannt, dass ein solcher Piezoaktor mit Metallfolien als Bestandteil der Außenelektroden versehen werden kann, die jeweils zumindest im Bereich von neutralen Schichten im Aufbau des Piezoelements Ausgleichswellen aufweisen.

Die Außenkontaktierung kann bei den bekannten Piezoaktoren beispielsweise mit einem beschichteten Sieb doppellagig ausgeführt werden und während der Anbindung mittels eines Lötprozesses werden alle Webknoten des Siebes fest verklammert und mit Lot angebunden. Die zuvor erwähnte gewünschte Beweglichkeit des Siebgewebes wird dabei in der Regel jedoch stark reduziert und kann nur eingeschränkt genutzt werden.

In der Schrift DE 102 36 986 A1 ist ein Piezoaktor mit Außenelektroden gezeigt, wobei als flexibler Teil der Außenelektrode eine wendelförmige Außenelektrode vorgesehen ist.

In der Schrift WO 03/105246 A2 ist ein Aktor gezeigt, wobei dessen elastische Außenelektroden in Schlitz- oder Mäanderform ausgestaltet sind.

DE 199 17 728 A1 offenbart einen Aktor mit Außenelektroden, wobei diese ein flexibles Blechteil mit herausgebogenen Ausstanzungen aufweisen und die mit einer Grundmetallisierung kontaktiert sind.

### Offenbarung der Erfindung

Die Erfindung geht von einem eingangs beschriebenen Piezoaktor aus, der mit einem Mehrschichtaufbau von Piezolagen in einem Piezoelement und zwischen den Piezolagen angeordneten Innenelektroden versehen ist. Die Innenelektroden sind in Richtung des Lagenaufbaus des Piezoelements abwechselnd mit einer unterschiedlichen Polarität einer elektrischen Spannung über eine wechselseitige seitliche Kontaktierung beaufschlagt. Die Außenelektroden bestehen dabei mindestens aus einer eingebrannten Grundmetallisierung der Seitenflächen.

Gemäß der Erfindung ist die jeweilige Außenelektrode ein mit Ausstanzungen und/oder Vorprägungen versehenes flexibles Blechteil, das während des Einbrennens der Grundmetallisierung zumindest mit Teilen seiner Struktur leitend auf diese aufgebracht ist.

Das flexible Blechteil ist dabei durch Schneiden und/oder Stanzen in seiner Struktur zur Herstellung der Flexibilität aufgebrochen und die Ausstanzungen und/oder Ausschneidungen sind durch Ziehen vor dem Aufbringen auf die Grundmetallisierung vergrößert.

Gemäß eines Beispiels ist das flexible Blechteil durch Scheiden und/oder Stanzen in seiner Struktur zur Herstellung der Flexibilität aufgebrochen und die Ausstanzungen und/oder Ausschneidungen werden zur Kontaktierung mit der Grundmetallisierung vor dem Auf-bringen auf die Grundmetallisierung aus der Grundfläche herausgebogen.

Bei der Ausführungsform kann das Blechteil entweder aus einem Metall oder aus einem mit einer leitenden Beschichtung versehenen Material hergestellt sein.

Ein erfindungsgemäßer Piezoaktor kann in einem einfachen Herstellungsprozess nach einem Sinterprozess an den Seiten geschliffen und dann eine Grundmetallisierung mit Aufsetzen des Blechteils vorgenommen werden. Das Einbrennen der Grundmetallisierung mit dem Blechteil erfolgt dann anschlie-βend vor einem sogenannten Heiß- oder Frequenzpolen und einer abschließenden Tauchlackierung des Piezoelements bzw. des Piezoaktors.

Zusammenfassend gesehen kann mit dem erfindungsgemäßen Piezoaktor somit vor allem eine sichere und dauerhafte Außenkontaktierung der Innenelektroden des Piezoelementes erreicht werden. Die durch die Betätigung des Piezoaktors bewirkten Bewegungen innerhalb des Piezoelements führen zu unterschiedlichen Bewegungen in drei Achsen. In der Hauptbewegungs- bzw. Betätigungsrichtung (Z-Achse) dehnt sich ein solcher Piezoaktor beispielsweise um ca. 100-120 µm aus; in der X- und Y-Achse zieht er sich dagegen um ca. 40-50 µm zusammen.

Aus diesem Grund wird zum Beispiel beim eingangs erwähnten Stand der Technik die Außenkontaktierung mit einem beschichteten doppellagigen Sieb ausgeführt. Die elektrische Anbindung wird dann beim Stand der Technik mittels eines Lötprozesses vorgenommen, bei dem alle Webknoten des Siebes fest verklammert und unter Einschränkung der Beweglichkeit mit Lot abgebunden werden.

Mit der erfindungsgemäßen Ausführungsform wird eine kostengünstig herstellbare Außenanbindung der Innenelektroden geschaffen, die den zuvor beschriebenen Bewegungsanforderungen bzw. dem geforderten Dehnungsvermögen in den drei Achsrichtungen beispielsweise während einer Laufzeit von 10⁹ Lastspielen des Piezoaktors erfüllen. Es sind weiterhin reproduzierbare Bedingungen für weitere wirtschaftliche und prozesssichere Montageanbindungen, beispielsweise eines Aktorfußes durch Spaltschweißen geschaffen. Der bisher notwendige Arbeitsgang des Lötens entfällt komplett, da die Anbindung der Außenkontakte unmittelbar mit dem Einbrennen der Grundmetallisierung auf dem Piezoaktor, also mit direkter Prozesskopplung, erfolgt.

### Kurze Beschreibung der Zeichnungen

Ausführungsbeispiele des erfindungsgemäßen Piezoaktors werden anhand der Zeichnung erläutert. Es zeigen:
- Figur 1: einen Schnitt durch einen Piezoaktor mit einem Mehrschichtaufbau von Piezolagen und Innenelektroden sowie einer siebartigen Außenelektrode nach dem Stand der Technik,
- Figur 2a: eine Detailansicht eines Ausschnitts einer Seitenfläche eines Piezoaktors mit einer schematisch angedeuteten erfindungsgemäßen Außenkontaktierung,
- Figur 2b: eine Ansicht eines Beispiels der Außenkontaktierung nach der Figur 2a mit einer Biegespule,
- Figur 2c: eine Seitenansicht auf die Biegespule nach der Figur 2b,
- Figur 3a und 3b: eine Ausführung der Außenkontaktierung mit einem Blechteil mit Stanzungen vor einem Ziehen (Figur 3a) und nach dem Ziehen (Figur 3b),
- Figur 3c: die Aufbringung der Außenkontierung nach der Figur 3b auf die Grundmetallisierung des Piezoaktors,
- Figur 4a: ein weiteres Beispiel der Außenkontaktierung mit einem Blechteil mit Stanzungen,
- Figur 4b: eine Ansicht von herausgebogenen Strukturen aus dem Blechteil nach der Figur 4a und
- Figur 4c: eine Seitenansicht des auf die Grundmetallisierung des Piezoaktors aufgebrachten Blechteils nach den Figuren 4a und 4b.

### Ausführungsformen der Erfindung

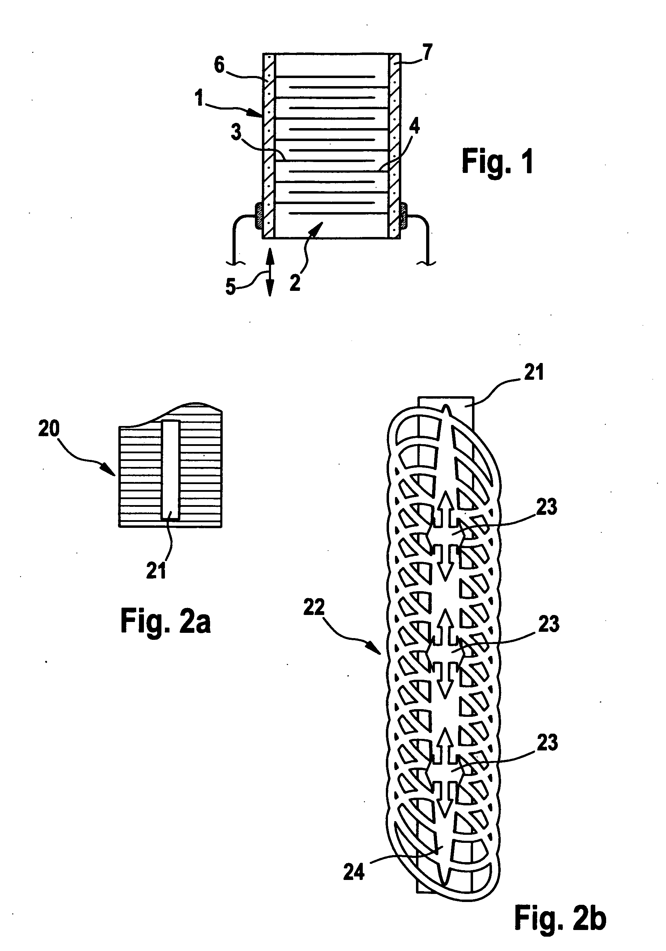

In Figur 1 ist ein beispielsweise aus dem eingangs erwähnten Stand der Technik DE 19928190 A1 bekannter Piezoaktor 1 gezeigt, der ein Piezoelement 2 aus Piezolagen oder -folien aufweist, die unter Ausnutzung des Piezoeffekts bei Anlage einer elektrischen Spannung an Innenelektroden 3 und 4 eine mechanische Reaktion des Piezoaktors 1 in axialer Richtung (Pfeil 5) erfolgt.

Die Innenelektroden 3 und 4 sind dabei in Richtung des Lagenaufbaus des Piezoelements 2 abwechselnd mit einer unterschiedlichen Polarität einer elektrischen Spannung beaufschlagt. Dies wird durch eine wechselseitige seitliche Kontaktierung der Innenelektroden 3 und 4 über netz- oder siebartige Außenelektroden 6 und 7 erreicht, über die die elektrische Spannung zuführbar ist, wobei die Außenelektroden 6 und 7 in der Regel mindestens aus einer eingebrannten Grundmetallisierung der Seitenflächen des Piezoaktors 1 bestehen, auf die die netz- oder siebartigen Außenelektroden 6 und 7 bei dem aus dem Stand der Technik bekannten Piezoaktor 1 aufgelötet sind. Der Piezoaktor 1 kann dann über ein hier nicht dargestelltes Fuß-und/oder Kopfteil fest in ein Gehäuse, beispielsweise das Gehäuse eines Einspritzventils für Kraftfahrzeuge zur Steuerung des Ventils, eingebettet werden und damit Bestandteil eines sogenannten Piezoinjektors sein.

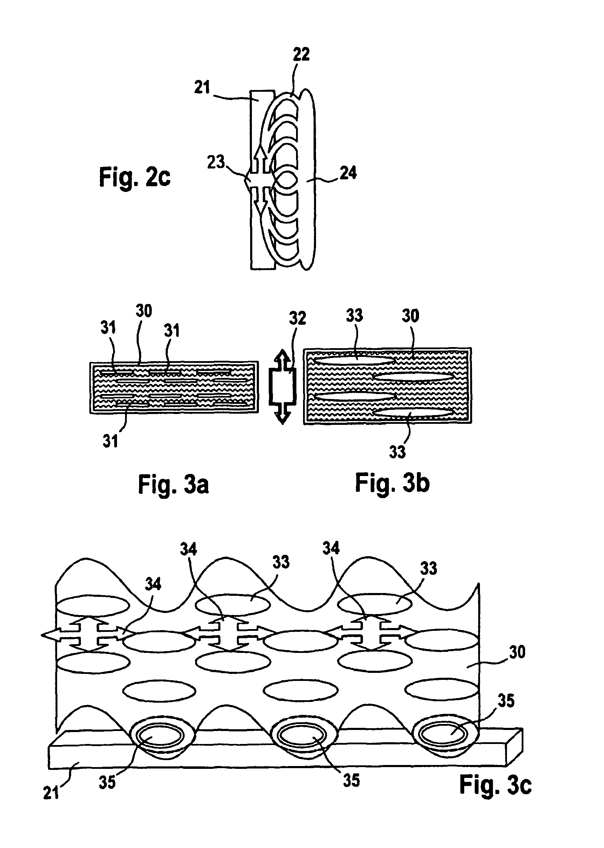

Anhand von Figur 2a, 2b und 2c soll nun ein Beispiel erläutert werden. In der Figur 2a ist ein Teil der Seitenfläche eines Piezoaktors 20 gezeigt, auf dem eine Schicht 21 für eine Außenelektrode für die Kontaktierung der hier nur schematisch angedeuteten Innenelektroden angebracht ist. Die Schicht 21 ist während der Grundmetallisierung der Seitenfläche mit eingebrannt worden.

Aus der Figur 2b ist im Detail das Beispiel einer Au-βenelektrode ersichtlich, die aus einer sogenannten Biegespule 22 besteht. Die Wicklungen der Biegspule 22 sind hier auch während des Einbrennens der Schicht 21 bzw. der Grundmetallisierung mit dem Piezoaktor 20 kontaktiert und erfüllen durch ihre mit Pfeilen 23 angedeuteten Bewegungsspielräume eine sichere Kontaktierung auch bei den in der allgemeinen Beschreibung erwähnten Bewegungen des Piezoaktors 20 in den drei Achsen. Es ist hier ferner noch eine Verstärkungsleiste 24 vorhanden, die in der Höhe gestaucht sein kann. Aus der Figur 2c ist noch eine Seitenansicht auf die Anordnung nach der Figur 2b ersichtlich.

In Figur 3a, 3b und 3c ist ein Ausführungsbeispiel der Erfindung mit einer aus einem Blechteil 30 geformten Außenelektrode gezeigt. Im Blechteil 30 sind zunächst Ausstanzungen 31 eingebracht, die, wie mit dem Pfeil 32 angedeutet, durch Ziehen in der dargestellten Richtung zu größeren Freiräumen 33 werden, die dann ebenfalls die Bewegungen (siehe Pfeile 34 aus der Figur 3c) des Piezoaktors 20 in den drei Achsen ausgleichen können. Im unteren Bereich sind die Kontaktierungen 35 mit der Schicht 21 bzw. mit der Grundmetallisierung ersichtlich.

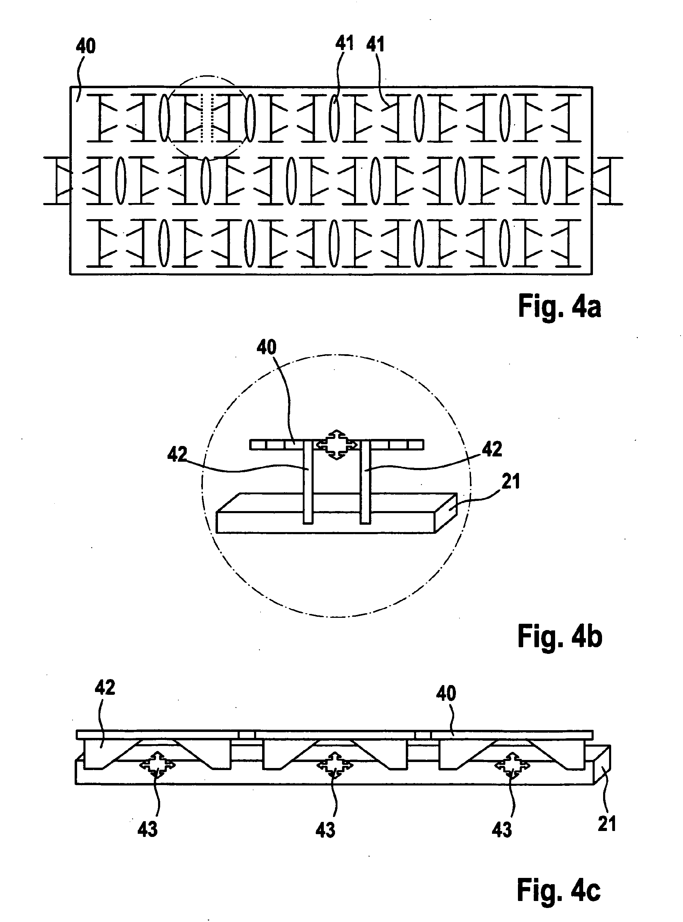

Ein weiteres Beispiel ist in Figur 4a, 4b und 4c dargestellt, bei dem ebenfalls ein Blechteil 40 als Ausgangselement für die Außenelektrode genommen wird. Auch hier sind Ausstanzungen 41 vorhanden, die durch Ziehen zu größeren Freiräumen gestaltet werden. Aus der Figur 4b sind im Detail noch herausgebogene Elemente 42 ersichtlich mit denen die Kontaktierungen mit der Schicht 21 bzw. mit der Grundmetallisierung durchgeführt werden.

Aus der Figur 4c ist noch eine Seitenansicht auf die Anordnung nach der Figur 4b ersichtlich, aus der erkennbar ist, wie auch hier die Bewegungen gemäß der Pfeile 43 des Piezoaktors 20 in den drei Achsen gewährleistet wird.

## Patentansprüche

1. Piezoaktor, mit einem Mehrschichtaufbau von Piezolagen in einem Piezoelement (2) und zwischen den Piezolagen angeordneten Innenelektroden (3,4), die in Richtung des Lagenaufbaus des Piezoelements (2) abwechselnd mit einer unterschiedlichen Polarität einer elektrischen Spannung beaufschlagt sind und einer wechselseitigen seitlichen Kontaktierung der Innenelektroden (3,4) über Außenelektroden (6,7), über die die elektrische Spannung zuführbar ist, wobei die Außenelektroden (6,7) mindestens aus einer eingebrannten Grundmetallisierung der Seitenflächen bestehen, wobei die jeweilige Außenelektrode ein mit Ausstanzungen (31;41) und/oder Vorprägungen versehenes, flexibles Blechteil (30;40) ist, das beim Einbrennen der Grundmetallisierung zumindest mit Teilen seiner Struktur leitend auf diese aufgebracht ist,
**dadurch gekennzeichnet, dass** das flexible Blechteil (30;40) durch Schneiden und/oder Stanzen in seiner Struktur zur Herstellung der Flexibilität aufgebrochen ist und die Ausstanzungen (21;31) und/oder Ausschneidungen durch Ziehen vor dem Aufbringen auf die Grundmetallisierung vergrößert sind.

2. Piezoaktor nach Anspruch 1, **dadurch gekennzeichnet, dass** das Blechteil (30;40) aus einem mit einer leitenden Beschichtung versehenen Material hergestellt sind.

3. Verfahren zur Herstellung eines Piezoaktors (20) nach einem der vorhergehenden Ansprüche, **dadurch gekennzeichnet, dass** das Piezoelement (2) nach einem Sinterprozess an den Seiten geschliffen wird, dass eine Grundmetallisierung mit Aufsetzen des Blechteils (30;40) vorgenommen wird, dass ein Einbrennen der Grundmetallisierung mit dem Blechteil (30;40) durchgeführt wird, dass ein Heißpolen erfolgt und dass eine abschließende Tauchlackierung des Piezoaktors (20) vorgenommen wird.

## Claims

1. Piezo actuator having a multi-layer structure of piezo layers in a piezo element (2) and inner electrodes (3, 4), which are arranged between the piezo layers and to which a different polarity of an electrical voltage is applied in alternation in the direction of the layer structure of the piezo element (2), and with alternating lateral contact-connection of the inner electrodes (3, 4) via outer electrodes (6, 7) via which the electrical voltage can be supplied, wherein the outer electrodes (6, 7) consist at least of a baked base metallization of the side surfaces, wherein the respective outer electrode is a flexible sheet metal part (30; 40) which is provided with punched-out sections (31; 41) and/or pre-stamped sections and, during the baking of the base metallization, is applied conductively to the latter at least with parts of its structure, **characterized in that** the flexible sheet metal part (30; 40) is broken open by cutting and/or punching in its structure to establish the flexibility, and the punched-out sections (21; 31) and/or cutouts are enlarged by pulling before said sheet metal part is applied to the base metallization.

2. Piezo actuator according to Claim 1, **characterized in that** the sheet metal part (30; 40) is produced from a material provided with a conductive coating.

3. Method for producing a piezo actuator (20) according to either of the preceding claims, **characterized in that** the piezo element (2) is ground at the sides after a sintering process, **in that** a base metallization is performed by attaching the sheet metal part (30; 40), **in that** baking of the base metallization with the sheet metal part (30; 40) is carried out, **in that** hot poling is effected and **in that** conclusive dip coating of the piezo actuator (20) is performed.

## Revendications

1. Piézoactionneur doté d'un agencement stratifié de couches piézoélectriques disposées dans un élément piézoélectrique (2) et d'électrodes intérieures (3, 4) disposées entre les couches piézoélectriques et sur lesquelles des tensions électriques de polarités différentes sont appliquées en alternance dans la direction de la stratification de l'élément piézoélectrique (2),
le piézoactionneur présentant un contact latéral alterné entre les électrodes intérieures (3, 4) par l'intermédiaire d'électrodes extérieures (6, 7) par lesquelles la tension électrique peut être amenée,
les électrodes extérieures (6, 7) étant constituées d'au moins une métallisation de base incorporée par cuisson,
chaque électrode extérieure étant une pièce (30; 40) en tôle flexible dotée de découpes (31; 41) et/ou de saillies et qui, lors de l'incorporation de la métallisation de base par cuisson, est appliquée sur elle de manière conductrice par des parties de sa structure,
**caractérisé en ce que**
la pièce (30; 40) en tôle flexible est découpée par découpe et/ou estampage dans sa structure en vue d'établir sa flexibilité et
**en ce que** les découpes estampées (21; 31) et/ou les découpes sont agrandies par traction avant d'être appliquées sur la métallisation de base.

2. Piézoactionneur selon la revendication 1, **caractérisé en ce que** la pièce (30; 40) en tôle est réalisée en un matériau doté d'un revêtement conducteur.

3. Procédé de fabrication d'un piézoactionneur (20) selon l'une des revendications précédentes, **caractérisé en ce que** le piézoélément (2) est meulé sur ses côtés après une opération de frittage, **en ce qu'**une métallisation de base est réalisée en même temps que la pose de la pièce (30; 40) en tôle, **en ce que** la métallisation de base est incorporée par cuisson avec la pièce (30; 40) en tôle, **en ce qu'**un polissage à chaud est réalisé et **en ce qu'**une peinture finale du piézoactionneur (20) est réalisée par immersion.
